(19) **Europäisches Patentamt European Patent Office Office européen des brevets**

(11) **EP 4 733 785 A1**

(12) **EUROPEAN PATENT APPLICATION**
published in accordance with Art. 153(4) EPC

(43) Date of publication:
29.04.2026 Bulletin 2026/18

(21) Application number: 24852248.4

(22) Date of filing: 05.08.2024

(51) International Patent Classification (IPC):
$G01R\ 31/389^{(2019.01)}$     $G01R\ 31/396^{(2019.01)}$
$G01R\ 31/392^{(2019.01)}$     $G01R\ 31/385^{(2019.01)}$
$G01R\ 31/382^{(2019.01)}$     $G01R\ 19/165^{(2006.01)}$
$G01R\ 27/02^{(2006.01)}$     $H01M\ 4/36^{(2006.01)}$

(52) Cooperative Patent Classification (CPC):
G01R 19/165; G01R 27/02; G01R 31/382;
G01R 31/385; G01R 31/389; G01R 31/392;
G01R 31/396; H01M 4/36

(86) International application number:
PCT/KR2024/011477

(87) International publication number:
WO 2025/033894 (13.02.2025 Gazette 2025/07)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 04.08.2023 KR 20230102310
07.08.2023 KR 20230102680
02.08.2024 KR 20240102964

(71) Applicant: **LG Energy Solution, Ltd.
Seoul 07335 (KR)**

(72) Inventors:
• **HWANG, Insang**
**Daejeon 34122 (KR)**
• **KIM, Yojin**
**Daejeon 34122 (KR)**
• **PARK, Jinseo**
**Daejeon 34122 (KR)**
• **JUNG, Haein**
**Daejeon 34122 (KR)**
• **CHO, Jaehyun**
**Daejeon 34122 (KR)**

(74) Representative: **Hoffmann Eitle
Patent- und Rechtsanwälte PartmbB
Arabellastraße 30
81925 München (DE)**

(54) **APPARATUS FOR DIAGNOSING RESISTANCE PROPERTY OF UNIT CELL, DIAGNOSING METHOD THEREOF, AND UNIT CELL FOR SECONDARY BATTERY SATISFYING SPECIFIC CONDITION ACCORDING TO METHOD THEREOF**

(57) The present disclosure provides a device for diagnosing resistance characteristic, comprising:
an acquisition unit that acquires a charging or discharging profile in a specified charge/discharge cycle of a unit cell;
a generation unit that generates a capacity voltage differential data representing a capacity voltage differential value(dQ/dV) of the unit cell in a charge or discharge cycle included in the specified charge/discharge cycle, based on the charging or discharging profile; and
a diagnosis unit that diagnoses resistance characteristic of the unit cell based on the capacity voltage differential data, a diagnosis method thereof, and a unit cell for secondary battery satisfying specific conditions according to the method.

FIG. 2

**Description**

**[TECHNICAL FIELD]**

Cross Citation with Related Application(s)

This application claims priority from and the benefit of Korean Patent Application No. 10-2023-0102310 filed on August 4, 2023, Korean Patent Application No. 10-2023-0102680 filed on August 7, 2023, and Korean Patent Application No. 10-2024-0102964 filed on August 2, 2024 in the Korean Intellectual Property Office, the disclosures of which are incorporated herein by reference in their entirety.

Embodiments of the present disclosure relate to a device for diagnosing resistance characteristic, a diagnosis method thereof, and a unit cell for secondary battery satisfying specific conditions according to the method.

**[BACKGROUND]**

In recent years, research and development on secondary batteries have been actively conducted. Here, a secondary battery is a battery that can be recharged and discharged, and includes both conventional Ni/Cd batteries, Ni/MH batteries, etc. and recent lithium-ion batteries. Among secondary batteries, lithium-ion batteries have an advantage of having a much higher energy density than conventional Ni/Cd batteries, Ni/MH batteries, etc. In addition, lithium-ion batteries can be manufactured to be small in size and light in weight, and are used as a power source for mobile devices, and recently, the use range thereof has expanded to power sources for electric vehicles, and lithium-ion batteries are attracting attention as a next-generation energy storage medium.

Generally, a secondary battery has a structure in which an electrode assembly is sealed with an electrolyte in an outer material, and two electrode terminals with different polarities are exposed to the outside. The electrode assembly includes a plurality of unit cells, wherein the unit cells have a structure in which a porous separator is interposed between at least a positive electrode plate and a negative electrode plate. Here, the unit cell may be composed of a mono cell in which a positive electrode and a negative electrode are positioned on both the outermost sides, a bi-cell in which the electrodes with the same polarity are positioned on both the outermost sides, or a half cell in which a positive electrode or a negative electrode is positioned between the separators on both the outermost sides.

Meanwhile, the importance of technology related to a management system for more efficiently use and management of secondary batteries is increasing. In particular, the management system must be able to accurately predict a degree of aging of the secondary batteries in order to appropriately adjust the charge or discharge output and capacity usage strategy of the secondary battery.

The maximum capacity of a secondary battery is not retained at the initial design capacity but decreases as the charge/discharge cycle progresses. Based on such characteristics, the degree of aging of the secondary battery is determined based on the resistance characteristic and capacity retention characteristic. Since the resistance characteristic of the secondary battery are directly related to the degree of aging, the degree of aging of the secondary battery can be predicted if there is a method capable of reliably determining the resistance characteristics.

In addition, if the degree of aging of each secondary battery can be predicted, it is possible to select a unit cell having more excellent characteristics based on this method.

**[DETAILED DESCRIPTION OF THE INVENTION]**

**[Technical Problem]**

It is an object of the present disclosure to provide a diagnosis device and a diagnosis method that utilize a new parameter capable of diagnosing the resistance characteristic of a unit cell rather than the capacity retention.

In particular, in the case of a high-manganese positive electrode material having the highest manganese(Mn) content, as the charge/discharge cycle progresses, the mutually opposite phenomena occur, where the capacity decreases due to an increase in resistance, and the capacity increases due to the activation of the manganese oxidation/reduction reaction. Therefore, the resistance characteristic cannot be diagnosed from the capacity retention over the entire voltage range, but a device and method for diagnosing the resistance characteristic according to the present disclosure are more preferable for diagnosing the resistance characteristic of a unit cell including a high-manganese positive electrode material.

It is another object of the present disclosure to provide a unit cell for a secondary battery having excellent effects defined using such parameters.

Technical tasks obtainable from the present disclosure are not limited to the above mentioned technical tasks, and additional other technical tasks not mentioned herein can be clearly understood from the following description by those skilled in the art.

**[Technical Solution]**

According to an embodiment of the present disclosure, there is provided a device for diagnosing resistance characteristic, comprising:

an acquisition unit that acquires a charging or discharging profile in a specified charge/discharge cycle of a unit cell;
a generation unit that generates a capacity voltage differential data representing a capacity voltage differential value(dQ/dV) of the unit cell in a charge or discharge cycle included in the specified charge/discharge cycle, based on the charging or discharging profile; and
a diagnosis unit that diagnoses resistance characteristic of the unit cell based on the capacity voltage differential data.

In the device for diagnosing resistance characteristic according to an embodiment of the present disclosure, the diagnosis unit diagnoses the resistance characteristic of the unit cell, based on the maximum capacity voltage differential value of the capacity voltage differential data in the charge cycle, and the minimum capacity voltage differential value of the capacity voltage differential data in the discharge cycle.

In the device for diagnosing resistance characteristic according to an embodiment of the present disclosure, the capacity voltage differential data,

represents a differential value of the capacity voltage to the voltage of the unit cell, and
further comprises an identification unit that identifies a target voltage corresponding to a maximum or minimum capacity voltage differential value of the unit cell based on the capacity voltage differential data, and
the diagnosis unit may diagnose the resistance characteristic of the unit cell based on the capacity voltage differential value retention at the target voltage of the unit cell.

In the device for diagnosing resistance characteristic according to an embodiment of the present disclosure, the generation unit generates a first capacity voltage differential data corresponding to the first charge/discharge cycle and a second capacity voltage differential data corresponding to the second charge/discharge cycle after the first charge/-discharge cycle, and

the identification unit identifies the target voltage corresponding to the maximum capacity voltage differential value in the charge cycle or the minimum capacity voltage differential value in the discharge cycle, included in the first charge/discharge cycle of the unit cell, based on the first capacity voltage differential data, and
the diagnosis unit may calculate the capacity voltage differential value retention based on the difference between the capacity voltage differential value at the target voltage of the charge cycle and the maximum capacity voltage differential value, or the difference between the capacity voltage differential value at the target voltage of the discharge cycle and the minimum capacity voltage differential value, included in the second charge/discharge cycle of the unit cell, based on the second capacity voltage differential data.

In the device for diagnosing resistance characteristic according to an embodiment of the present disclosure, the diagnosis unit may diagnose that as the capacity voltage differential value retention is smaller, the resistance increase of the unit cell is higher.

In the device for diagnosing resistance characteristic according to an embodiment of the present disclosure, the unit cell may include a high-manganese positive electrode having the highest manganese(Mn) content among the constituent components.

Meanwhile, according to an embodiment of the present disclosure, there is provided a method for diagnosing resistance characteristic comprising:

an operation that acquires a charging or discharging profile in a specified charge/discharge cycle of a unit cell;
an operation that generates a capacity voltage differential data representing a capacity voltage differential value(dQ/dV) of the unit cell in a charge or discharge cycle included in the specified charge/discharge cycle, based on the charging or discharging profile; and
an operation that diagnoses resistance characteristic of the unit cell based on the capacity voltage differential data.

In the method for diagnosing resistance characteristic according to an embodiment of the present disclosure, the operation that diagnoses resistance characteristic may include an operation that diagnoses the resistance characteristic of the unit cell, based on the maximum capacity voltage differential value of the capacity voltage differential data in the charge cycle, and the minimum capacity voltage differential value of the capacity voltage differential data in the discharge cycle.

In the method for diagnosing resistance characteristic according to an embodiment of the present disclosure, the capacity voltage differential data,

represents a differential value of the capacity voltage to the voltage of the unit cell, and
further comprises an operation that identifies a target voltage corresponding to a maximum or minimum capacity voltage differential value of the unit cell based on the capacity voltage differential data, and
the operation that diagnoses resistance characteristic includes an operation that diagnoses the resistance characteristic of the unit cell based on the capacity voltage differential value retention at the target voltage of the unit cell.

In the method for diagnosing resistance characteristic according to an embodiment of the present disclosure, the operation that generates capacity voltage differential data includes an operation that generates a first capacity voltage differential data corresponding to the first charge/discharge cycle and a second capacity voltage differential data corresponding to the second charge/discharge cycle after the first charge/discharge cycle, and

the operation that identifies a target voltage includes an operation that identifies the target voltage corresponding to the maximum capacity voltage differential value in the charge cycle or the minimum capacity voltage differential value in the discharge cycle, included in the first charge/discharge cycle of the unit cell, based on the first capacity voltage differential data, and
the operation that diagnoses resistance characteristic includes an operation that calculates the capacity voltage differential value retention, based on the difference between the capacity voltage differential value at the target voltage of the charge cycle and the maximum capacity voltage differential value, or the difference between the capacity voltage differential value at the target voltage of the discharge cycle and the minimum capacity voltage differential value, included in the second charge/discharge cycle of the unit cell, based on the second capacity voltage differential data.

In the method for diagnosing resistance characteristic according to an embodiment of the present disclosure, the operation that diagnoses resistance characteristic may include an operation that diagnoses that as the capacity voltage differential value retention is smaller, the resistance increase of the unit cell is higher.

In the method for diagnosing resistance characteristic according to an embodiment of the present disclosure, the unit cell may include a high-manganese positive electrode having the highest manganese(Mn) content among the constituent components.

Furthermore, according to an embodiment of the present disclosure, there is provided a unit cell for a secondary battery which satisfies the following Condition 1,

when a voltage corresponding to the maximum capacity voltage differential value($D_1$) obtained from a first capacity voltage differential data in a first charge cycle of the unit cell for a secondary battery is set as the target voltage($Vt$), and a capacity voltage differential value($D_2$) corresponding to the target voltage ($V_t$) is obtained from a second capacity voltage differential data in a second charge/discharge cycle of the unit cell, or
when a voltage corresponding to the minimum capacity voltage differential value($D_1$) obtained from a first capacity voltage differential data in the first discharge cycle of the unit cell for a secondary battery is set as the target voltage ($V_t$), and a capacity voltage differential value ($D_2$) corresponding to the target voltage ($V_t$) is obtained from the second capacity voltage differential data in the second charge/discharge cycle of the unit cell.

[Condition 1]

$$D_2/D_1 * 100\% > 70\%.$$

In the unit cell for a secondary battery according to an embodiment of the present disclosure, the charging of the unit cell may be performed in CC-CV charge mode at 0.1C to 1C in a range of 2V to 4.25V, or 3V to 4.3V, or 2V to 4.35V, and the discharging of the unit cell may be performed in CC charge mode at 0.1C to 1C in a range of 2V to 4.25V, or 3V to 4.3V, or 2V to 4.35V.

In the unit cell for a secondary battery according to an embodiment of the present disclosure, the unit cell may include a high-manganese positive electrode having the highest manganese(Mn) content among the constituent components.

**[BRIEF DESCRIPTION OF THE DRAWINGS]**

FIG. 1 is a graph showing the relationship between the minimum capacity voltage differential value retention at the target voltage of a unit cell and the resistance characteristic.
FIG. 2 is a graph showing the relationship between the maximum capacity voltage differential value retention at the target voltage of a unit cell and the resistance characteristic.
FIG. 3 is a block diagram of the resistance characteristic diagnosis device according to one embodiment.
FIG. 4 is a diagram explaining an embodiment in which the resistance characteristic diagnosis device according to one embodiment identifies the minimum capacity voltage differential value at the target voltage of a unit cell in multiple discharge cycles.
FIG. 5 is a diagram explaining an embodiment in which the resistance characteristic diagnosis device according to one embodiment identifies the maximum capacity voltage differential value at the target voltage of a unit cell in multiple charge cycles.
FIG. 6 is an operation flowchart of the device for diagnosing a resistance increase according to one embodiment.
FIG. 7 is an operation flowchart of the resistance characteristic diagnosis device based on a discharging profile according to one embodiment.
FIG. 8 is an operation flowchart of the resistance characteristic diagnosis device based on a charging profile according to one embodiment.

**[DETAILED DESCRIPTION OF THE EMBODIMENTS]**

Below, various exemplary embodiments will be described with reference to the accompanying drawings. The following exemplary embodiments are non-limiting and illustrative only, and it should be understood that all suitable modification, equivalents and/or alternatives fall within the scope of the disclosure.

Various embodiments of the present disclosure and terms used in the embodiments are not intended to limit the technical characteristics, described in the present disclosure, to specific embodiments, and should be understood as including various changes, equivalents or alternatives of a corresponding embodiment. In relation to the description of the drawings, similar reference numerals may be used for similar or related elements. A singular form of a noun corresponding to an item may include one item or a plurality of items unless explicitly described otherwise in the context.

In the present disclosure, each of phrases, such as "A or B", "at least one of A and B", "at least one of A or B", "A, B or C", "at least one of A, B and C", and "at least one of A, B, or C", may include any one of items listed along with a corresponding one of the phrases or all possible combinations of the listed items. Terms, such as "a first", "a second", "the first" or "the second", "A", "B", "(a)" or "(b)" may be used to merely distinguish between a corresponding element and another corresponding element, and do not limit corresponding elements in another aspect (e.g., importance or a sequence).

It is to be understood that if an element (e.g., a first element) is referred to, with or without the term "operatively" or "communicatively", as "coupled with," "coupled to," "connected with," or "connected to" another element (e.g., a second element), it means that the element may be connected to the other element directly (e.g., wiredly), wirelessly, or via a third element.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory(CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

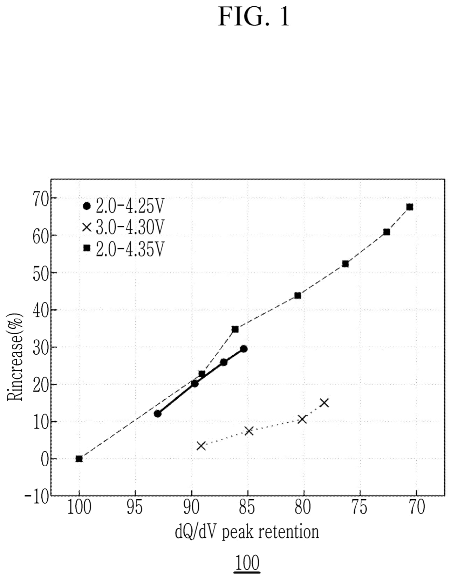

FIG. 1 is a graph showing the relationship between the minimum capacity voltage differential value retention at the target voltage of a unit cell and the resistance characteristic.

Referring to FIG. 1, a graph 100 showing the resistance increase relative to the minimum capacity voltage differential value retention in the discharge cycle of a unit cell that has gone through charge/discharge cycles of different voltage ranges (e.g., 2 V or more and 4.25 V or less, 3 V or more and 4.3 V or less, or 2 V or more and 4.35 V or less) can be confirmed. Here, the unit cell may include a high-manganese cathode having the highest manganese(Mn) content among the constituent components.

Referring to graph 100, it can be confirmed that in the case of the unit cell, the behavior of the minimum capacity voltage differential value retention and the resistance increase in the discharge cycle have a nearly linear relationship. For example, it can be confirmed that in the case of the unit cell, the resistance increase has a form that increases as the minimum capacity voltage differential value retention decreases, regardless of the voltage range of the charge/discharge cycle.

Namely, the resistance characteristic of the unit cell can be predicted based on the minimum capacity voltage differential value retention in the discharge cycle.

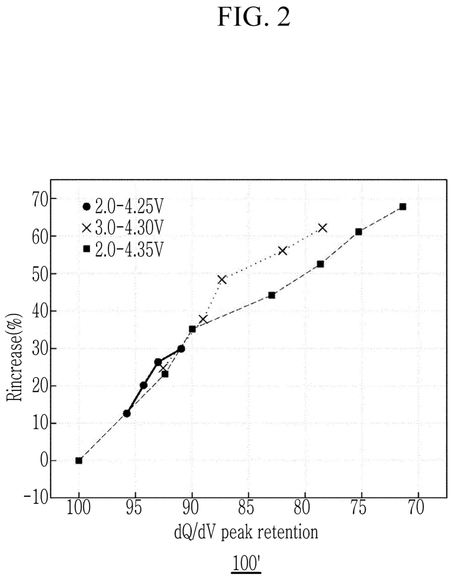

Similarly, FIG. 2 is a graph showing the relationship between the maximum capacity voltage differential value retention at the target voltage of a unit cell and the resistance characteristic.

Referring to FIG. 2, a graph 100' showing the resistance increase relative to the maximum capacity voltage differential value retention rate in the charging cycle of a unit cell that has gone through charge/discharge cycles of different voltage ranges (e.g., 2 V or more and 4.25 V or less, 3 V or more and 4.3 V or less, or 2 V or more and 4.35 V or less) can be confirmed. Here, the unit cell may include a high-manganese cathode having the highest manganese(Mn) content among the constituent components.

Referring to graph 100', it can be confirmed that in the case of the unit cell, the behavior of the minimum capacity voltage differential value retention and the resistance increase in the charge cycle have a nearly linear relationship. For example, it can be confirmed that in the case of the unit cell, the resistance increase has a form that increases as the maximum capacity voltage differential value retention decreases, regardless of the voltage range of the charge/discharge cycle.

Namely, the resistance characteristic of the unit cell can be predicted based on the minimum capacity voltage differential value retention in the charge cycle.

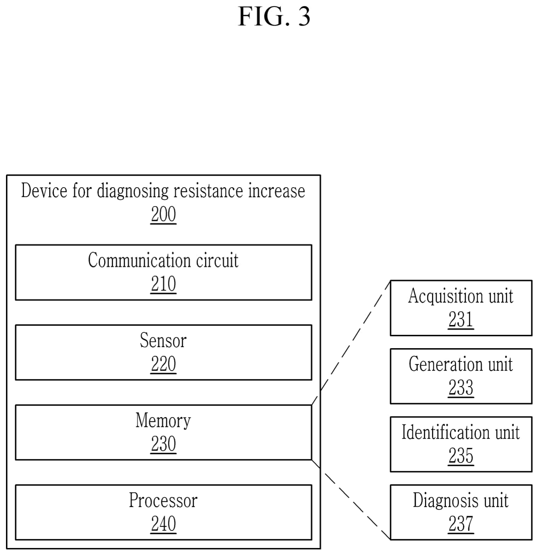

FIG. 3 is a block diagram of the resistance characteristic diagnosis device according to one embodiment.

According to one embodiment, the resistance characteristic diagnosis device 200 may include a communication circuit 210, a sensor 220, a memory 230, and/or a processor 240. According to one embodiment, the resistance characteristic diagnosis device 200 illustrated in FIG. 3 may further include at least one constituent component (e.g., a display, an input device, or an output device) other than the components illustrated in FIG. 3. According to one embodiment, the resistance characteristic diagnosis device 200 may receive values related to the state of the unit cell via the communication circuit 210 and/or the sensor 220. For example, the unit cell may be a unit cell including a high-manganese positive electrode having the highest manganese content among the constituent components. According to one embodiment, the values related to the state may include a charging or discharging profile representing a voltage according to a charge capacity or a discharge capacity when the unit cell is charged or discharged.

According to one embodiment, the communication circuit 210 establishes a wired communication channel and/or a wireless communication channel between the resistance characteristic diagnosis device 200 and the external electronic device and/or the external server, and can transmit and receive data to and from the external electronic device and/or the external server through the established communication channel. According to one embodiment, the communication circuit 210 can receive values related to the state of the unit cell from the external electronic device and/or the external server.

According to one embodiment, the sensor 220 can measure values related to the state of the unit cell.

According to one embodiment, in the resistance characteristic diagnosis device 200, either one of the communication circuit 210 or the sensor 220 may be omitted. For example, if the sensor 220 is omitted, the resistance characteristic diagnosis device 200 can receive values related to the state of the unit cell from the external electronic device and/or the external server only through the communication circuit 210. In another embodiment, if the communication circuit 210 is omitted, the resistance characteristic diagnosis device 200 can measure values related to the state of the unit cell only through the sensor 220.

According to one embodiment, the memory 230 may include volatile memory and/or nonvolatile memory.

In one embodiment, the memory 230 may store data used by at least one component (e.g., processor 240) of the resistance characteristic diagnosis device 200. For example, the data may include software (or instructions related thereto), input data, or output data. In one embodiment, the instructions may, when executed by the processor 240, cause the resistance characteristic diagnosis device 200 to perform the operation defined by the instructions.

In one embodiment, the memory 230 may include one or more software (e.g., an acquisition unit 231, a generation unit 233, an identification unit 235, and/or a diagnosis unit 237.

In one embodiment, the processor 240 may include a central processing unit, an application processor, a graphics processing unit, a neural processing unit(NPU), an image signal processor, a sensor hub processor, or a communication processor.

In one embodiment, the processor 240 may execute software (e.g., an acquisition unit 231, a generation unit 233, an identification unit 235, and/or a diagnosis unit 237) to control at least one other component (e.g., a hardware or software component) of the resistance characteristic diagnosis device 200 connected to the processor 240 and perform various data processing or calculations.

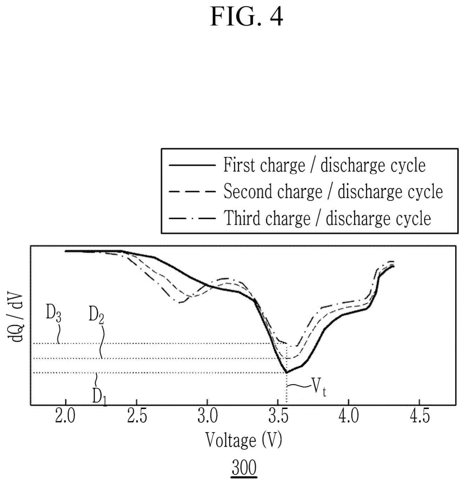

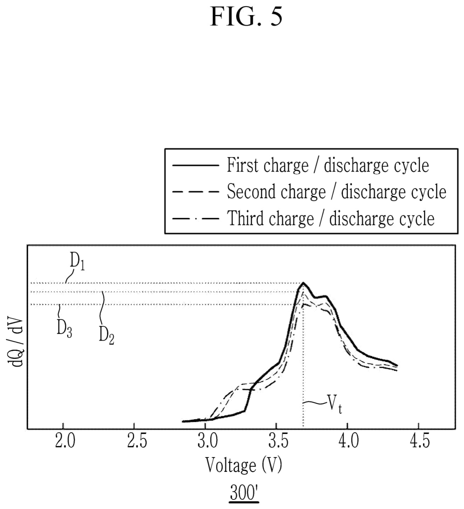

Next, a method in which the resistance characteristic diagnosis device 200 diagnoses resistance characteristic of a unit cell via the acquisition unit 231, the generation unit 233, the identification unit 235, and/or the diagnosis unit 237 is described with further reference to FIGS. 4 and 5.

Specifically, FIG. 4 is a diagram explaining an embodiment in which the resistance characteristic diagnosis device according to one embodiment identifies the minimum capacity voltage differential value at the target voltage of a unit cell in multiple discharge cycles. FIG. 5 is a diagram explaining an embodiment in which the resistance characteristic diagnosis device according to one embodiment identifies the maximum capacity voltage differential value at the target voltage of a unit cell in multiple charge cycles.

First, referring to FIGS. 3 and 4 together, according to one embodiment, the acquisition unit 231 can acquire a discharging profile in a specified charge/discharge cycle of a unit cell. According to one embodiment, the acquisition unit 231 can acquire a discharging profile from an external electronic device and/or an external server connected via a wired and/or wireless network using a communication circuit 210. According to another embodiment, the acquisition unit 231 can also acquire a discharging profile by measuring a discharge capacity and voltage during discharge of a unit cell via a sensor 220.

According to one embodiment, the acquisition unit 231 can acquire a first discharging profile in the first charge/discharge cycle of FIG. 3, a second discharging profile in the second charge/discharge cycle, and a third discharging profile in the third charge/discharge cycle. Here, the first charge/discharge cycle is a first charge/discharge cycle performed for the unit cell, and the second charge/discharge cycle (or, the third charge/discharge cycle) may be a Nth charge/discharge cycle performed for the same unit cell. As an example, the second charge/discharge cycle may be the 100th charge/discharge cycle, and the third charge/discharge cycle may be the 300th charge/discharge cycle. In other words, it may be the second or third measured charge/discharge cycle regardless of the number of cycles.

According to one embodiment, the generation unit 233 may generate capacity voltage differential data in a discharge cycle included in the specified charge/discharge cycle based on the discharging profile acquired by the acquisition unit 231. Here, the capacity voltage differential data may represent a capacity voltage differential value of a unit cell.

For example, the capacity voltage differential data may represent a capacity voltage differential value with respect to the voltage of a unit cell, as in the graph 300 of FIG. 4. Referring to the graph 300 of FIG. 4, the generation unit 233 may generate a first capacity voltage differential data corresponding to the first charge/discharge cycle, a second capacity voltage differential data corresponding to the second charge/discharge cycle, and a third capacity voltage differential data corresponding to the third charge/discharge cycle.

According to one embodiment, the identification unit 235 can identify a target voltage corresponding to the minimum capacity voltage differential value of the unit cell based on the capacity voltage differential data generated by the generation unit 233. For example, referring to the graph 300 of FIG. 4, the identification unit 235 can identify a target voltage $(V_t)$ corresponding to the minimum capacity voltage differential value$(D_1)$ based on the capacity voltage differential data corresponding to the first charge/discharge cycle of the unit cell.

According to one embodiment, the diagnosis unit 237 can diagnose the resistance characteristic of the unit cell based on the capacity voltage differential data generated by the generation unit 233. For example, the diagnosis unit 237 can diagnose the resistance characteristic of the unit cell based on the minimum capacity voltage differential value of the capacity voltage differential data.

According to one embodiment, the diagnosis unit 237 can diagnose the resistance characteristic of the unit cell based on the capacity voltage differential value retention at the target voltage identified by the identification unit 235. For example, referring to the graph 300 of FIG. 4, the diagnosis unit 237 can calculate the capacity voltage differential value retention based on the difference between the minimum capacity-voltage differential value$(D_1)$ at the target voltage$(V_t)$ of the first charge/discharge cycle and the capacity-voltage differential value$(D_2)$ at the target voltage$(V_t)$ of the second charge/discharge cycle and/or the capacity voltage differential value $(D_3)$ at the target voltage$(V_t)$ of the third charge/-discharge cycle.

According to one embodiment, the diagnosis unit 237 can diagnose that as the calculated capacity voltage differential value retention is smaller, the resistance increase of the unit cell is higher. For example, the diagnosis unit 237 can diagnose the resistance increase of the unit cell using the capacity voltage differential value retention-resistance increase table stored in the memory 230. Here, the table may be a table showing the resistance increase corresponding to a predetermined capacity voltage differential value retention of the unit cell. As another example, the diagnosis unit 237 may input the capacity voltage differential retention into a resistance increase calculation formula stored in the memory 230 to calculate the resistance increase of the unit cell.

Similarly, referring to FIGS. 3 and 5 together, the acquisition unit 231 can acquire a charging profile in a specified charge/discharge cycle of the unit cell. According to one embodiment, the acquisition unit 231 may acquire a charging profile from an external electronic device and/or an external server connected via a wired and/or wireless network using a communication circuit 210. According to another embodiment, the acquisition unit 231 may acquire a charging profile by measuring a charging capacity and voltage during charging of a unit cell via a sensor 220.

According to one embodiment, the acquisition unit 231 can acquire a first charging profile in the first charge/discharge cycle of FIG. 5, a second charging profile in the second charge/discharge cycle, and a third charging profile in the third charge/discharge cycle. Here, the first charge/discharge cycle may be the first charge/discharge cycle performed for the unit cell, and the second charge/discharge cycle (or, the third charge/discharge cycle) may be the Nth charge/discharge cycle performed for the same unit cell. As an example, the second charge/discharge cycle may be the 100th charge/discharge cycle, and the third charge/discharge cycle may be the 300th charge/discharge cycle. In other words, they may be the second and third measured charge/discharge cycles regardless of the number of cycles.

According to one embodiment, the generation unit 233 may generate a capacity voltage differential data in a charging cycle included in the specified charge/discharge cycle based on the charging profile acquired by the acquisition unit 231. Here, the capacity voltage differential data may represent a capacity voltage differential value of a unit cell.

For example, the capacity voltage differential data may represent a capacity voltage differential value with respect to the voltage of a unit cell, as in the graph 300' of FIG. 5. Referring to the graph 300' of FIG. 5, the generation unit 233 may generate a first capacity voltage differential data corresponding to the first charge/discharge cycle, a second capacity voltage differential data corresponding to the second charge/discharge cycle, and a third capacity voltage differential data corresponding to the third charge/discharge cycle.

According to one embodiment, the identification unit 235 can identify a target voltage corresponding to the maximum capacity voltage differential value of the unit cell based on the capacity voltage differential data generated by the generation unit 233. For example, referring to the graph 300' of FIG. 5, the identification unit 235 may identify a target voltage($V_t$) corresponding to the maximum capacity voltage differential value($D_1$) based on the capacity voltage differential data corresponding to the first charge/discharge cycle of the unit cell.

According to one embodiment, the diagnosis unit 237 can diagnose the resistance characteristic of the unit cell based on the capacity voltage differential data generated by the generation unit 233. For example, the diagnosis unit 237 can diagnose the resistance characteristic of the unit cell based on the maximum capacity voltage differential value of the capacity voltage differential data.

According to one embodiment, the diagnosis unit 237 can diagnose the resistance characteristic of the unit cell based on the capacity voltage differential value retention at the target voltage identified by the identification unit 235. For example, referring to the graph 300' of FIG. 5, the diagnosis unit 237 can calculate the capacity voltage differential value retention based on the difference between the maximum capacity voltage differential value($D_1$) at the target voltage($V_t$) of the first charge/discharge cycle and the capacity voltage differential value($D_2$) at the target voltage($V_t$) of the second charge/discharge cycle and/or the capacity voltage differential value($D_3$) at the target voltage($V_t$) of the third charge/discharge cycle.

According to one embodiment, the diagnosis unit 237 can diagnose that as the calculated capacity voltage differential value retention is smaller, the resistance increase of the unit cell is higher. For example, the diagnosis unit 237 can diagnose the resistance increase of the unit cell using the capacity voltage differential value retention-resistance increase table stored in the memory 230. Here, the table may be a table showing the resistance increase corresponding to a predetermined capacity voltage differential value retention of the unit cell. As another example, the diagnosis unit 237 may input the capacity voltage differential value retention into the resistance increase calculation formula stored in the memory 230 to calculate the resistance increase of the unit cell.

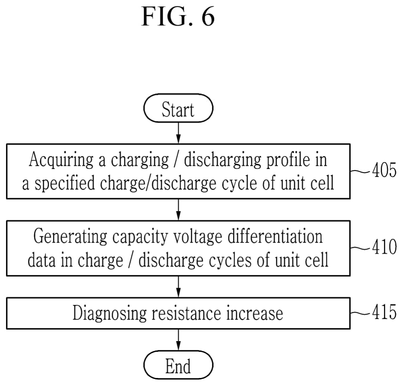

FIG. 6 is an operation flowchart of the device for diagnosing resistance characteristic according to one embodiment. FIG. 6 can be explained using the configuration of FIG. 3 (e.g., the resistance characteristic diagnosis device 200).

The embodiment illustrated in FIG. 6 is only one embodiment, the order of steps according to various embodiments of the present disclosure may be different those illustrated in FIG. 6, and some steps illustrated in FIG. 6 may be omitted, or the order between steps may be changed, or steps may be merged.

In operation 405, the resistance characteristic diagnosis device 200 can acquire a charging or discharging profile in a specified charge/discharge cycle of the unit cell.

In operation 410, the resistance characteristic diagnosis device 200 can generate capacity voltage differential data in a charge or discharge cycle included in the specified charge/discharge cycle based on the charging or discharging profile acquired in operation 405. Here, the capacity voltage differential data can represent a capacity voltage differential value of a unit cell. For example, the capacity voltage differential data can represent a capacity voltage differential value with respect to the voltage of the unit cell, such as the graphs 300 and 300' of FIGS. 4 and 5.

In operation 415, the resistance characteristic diagnosis device 200 can diagnose the resistance characteristic of the unit cell, specifically, the resistance increase, based on the capacity voltage differential data generated in operation 410. According to one embodiment, the resistance characteristic diagnosis device 200 can diagnose the resistance characteristic of the unit cell based on the minimum capacity voltage differential value or the maximum capacity voltage differential value of the capacity voltage differential data. According to one embodiment, the resistance characteristic diagnosis device 200 can diagnose the resistance characteristic of the unit cell based on the capacity voltage differential value retention.

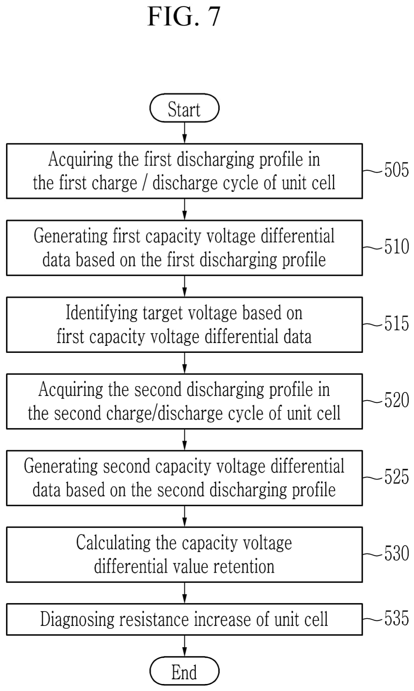

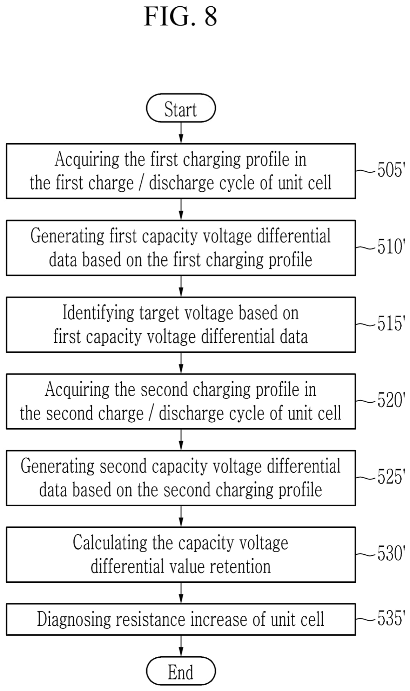

Specific operations in which the resistance characteristic diagnosis device 200 diagnoses the resistance characteristic may be explained with reference to FIGS. 7 and 8, which will be mentioned later.

Specifically, FIG. 7 is an operation flowchart of the resistance characteristic diagnosis device based on a discharging profile according to one embodiment, and FIG. 8 is an operation flowchart of the resistance characteristic diagnosis device based on a charging profile according to one embodiment. FIGS. 7 and 8 can be explained using the configuration of FIG. 2 (e.g., the resistance characteristic diagnosis device 200).

The embodiments illustrated in FIGS. 7 and 8 are only one embodiment, the order of steps according to various embodiments of the present disclosure may be different from those illustrated in FIGS. 7 and 8, and some steps illustrated in FIGS. 7 and 8 may be omitted, or the order between steps may be changed, or steps may be merged.

First, referring to FIG. 7 together with FIG. 2, in operation 505, the resistance characteristic diagnosis device 200 can acquire a first discharging profile in the first charge/discharge cycle of the unit cell. Here, the first charge/discharge cycle may be the first charge/discharge cycle performed for the unit cell.

In operation 510, the resistance characteristic diagnosis device 200 can generate a first capacity voltage differential data based on the first discharging profile obtained in operation 505. Here, the capacity voltage differential data may represent a capacity voltage differential value of the unit cell. For example, the capacity voltage differential data may represent a capacity voltage differential value with respect to the voltage of the unit cell, as in the graph 300 of FIG. 4.

In operation 515, the resistance characteristic diagnosis device 200 can identify a target voltage based on the first capacity voltage differential data generated in operation 510. According to one embodiment, the resistance characteristic diagnosis device 200 can identify a target voltage corresponding to a minimum capacity voltage differential value of a unit cell based on the first capacity voltage differential data.

In operation 520, the resistance characteristic diagnosis device 200 can acquire a second discharging profile in a second charge/discharge cycle of the unit cell. Here, the second charge/discharge cycle may be an Nth (e.g., 100th) charge/discharge cycle performed for the same unit cell.

In operation 525, the resistance characteristic diagnosis device 200 can generate a second capacity voltage differential data based on the second discharging profile obtained in operation 520.

In operation 530, the resistance characteristic diagnosis device 200 may calculate a capacity voltage differential value retention. According to one embodiment, the resistance characteristic diagnosis device 200 can calculate the capacity voltage differential value retention based on the first capacity voltage differential data generated in operation 510 and the second capacity voltage differential data generated in operation 525. For example, the resistance characteristic diagnosis device 200 can calculate the capacity voltage differential value retention based on the difference between the minimum capacity voltage differential value at the target voltage of the first charge/discharge cycle and the capacity voltage differential value at the target voltage of the second charge/discharge cycle.

In operation 535, the resistance characteristic diagnosis device 200 can diagnose the resistance characteristic of the unit cell based on the capacity voltage differential value retention calculated in operation 530. According to one embodiment, the resistance characteristic diagnosis device 200 can diagnose that as the calculated capacity voltage differential value retention is smaller, the resistance increase of the unit cell is higher. For example, the resistance characteristic diagnosis device 200 can diagnose the resistance increase of the unit cell using the capacity voltage differential value retention-resistance increase table stored in the memory 230. Here, the table may be a table showing the resistance increase corresponding to a predetermined capacity voltage differential value retention of the unit cell. As another example, the resistance characteristic diagnosis device 200 may also input the capacity voltage differential value retention into the resistance increase calculation formula stored in the memory 230 to calculate the resistance increase of the unit cell.

Similarly, referring to FIG. 8 together with FIG. 2, in operation 505', the resistance characteristic diagnosis device 200 can acquire a first charging profile in a first charge/discharge cycle of the unit cell. Here, the first charge/discharge cycle may be the first charge/discharge cycle performed for the unit cell.

In operation 510', the resistance characteristic diagnosis device 200 can generate a first capacity voltage differential data based on the first charging profile acquired in operation 505'. Here, the capacity voltage differential data can represent a capacity voltage differential value of the unit cell. For example, the capacity voltage differential data may represent a capacity voltage differential value with respect to the voltage of the unit cell, as in the graph 300' of FIG. 5.

In operation 515', the resistance characteristic diagnosis device 200 may identify a target voltage based on the first capacity voltage differential data generated in operation 510'. According to one embodiment, the resistance characteristic diagnosis device 200 can identify a target voltage corresponding to a maximum capacity voltage differential value of the unit cell based on the first capacity voltage differential data.

In operation 520', the resistance characteristic diagnosis device 200 can acquire a second charging profile in the second charge/discharge cycle of the unit cell. Here, the second charge/discharge cycle may be the Nth (e.g., 100th) charge/discharge cycle performed for the same unit cell.

In operation 525', the resistance characteristic diagnosis device 200 may generate a second capacity voltage differential data based on the second charging profile acquired in operation 520'.

In operation 530', the resistance characteristic diagnosis device 200 may calculate a capacity voltage differential value retention. According to one embodiment, the resistance characteristic diagnosis device 200 may calculate the capacity voltage differential value retention based on the first capacity voltage differential data generated in operation 510' and the second capacity voltage differential data generated in operation 525'. For example, the resistance characteristic diagnosis device 200 may calculate the capacity voltage differential value retention based on the difference between the maximum capacity voltage differential value at the target voltage of the first charge/discharge cycle and the capacity voltage differential value at the target voltage of the second charge/discharge cycle.

In operation 535', the resistance characteristic diagnosis device 200 may diagnose the resistance characteristic of the unit cell based on the capacity voltage differential value retention calculated in operation 530'. According to one embodiment, the resistance characteristic diagnosis device 200 can diagnose that as the calculated capacity voltage differential value retention is smaller, the resistance increase of the unit cell is higher. For example, the resistance characteristic diagnosis device 200 can diagnose the resistance increase of the unit cell using the capacity voltage differential value retention-resistance increase table stored in the memory 230. Here, the table may be a table showing the resistance increase corresponding to a predetermined capacity voltage differential value retention of the unit cell. As another example, the resistance characteristic diagnosis device 200 may input the capacity voltage differential value retention into the resistance increase calculation formula stored in the memory 230 to calculate the resistance increase of the unit cell.

On the other hand, the present disclosure provides a new parameter for diagnosing resistance characteristics so that the degree of aging of a battery can be determined from the resistance characteristics of the unit cell, thereby providing a unit cell for a secondary battery satisfying specific conditions.

Specifically, the unit cell for a secondary battery according to one embodiment of the present disclosure may satisfy the following condition 1,

when a voltage corresponding to the maximum capacity voltage differential value($D_1$) obtained from a first capacity voltage differential data in a first charge cycle of the unit cell for a secondary battery is set as the target voltage($Vt$), and a capacity voltage differential value($D_2$) corresponding to the target voltage($V_t$) is obtained from a second capacity voltage differential data in a second charge/discharge cycle of the unit cell, or
when a voltage corresponding to the minimum capacity voltage differential value($D_1$) obtained from a first capacity voltage differential data in the first discharge cycle of the unit cell for a secondary battery is set as the target voltage($V_t$), and a capacity voltage differential value($D_2$) corresponding to the target voltage($V_t$) is obtained from the second capacity voltage differential data in the second charge/discharge cycle of the unit cell.

[Condition 1]

$$D_2/D_1 * 100\% > 70\%.$$

More specifically, $D_2/D_1 \times 100\% > 80\%$ may be satisfied.

In this case, the charging of the unit cell may be performed in CC-CV charge mode at 0.1C to 1C in a range of 2V to 4.25V, or 3V to 4.3V, or 2V to 4.35V, and the discharging of the unit cell may be performed in CC charge mode at 0.1C to 1C in a range of 2V to 4.25V, or 3V to 4.3V, or 2V to 4.35V.

However, the first charge/discharge cycle and the second charge/discharge cycle are performed under the same charge and discharge conditions.

On the other hand, the components of the unit cell can be applied without limitation as long as they have a configuration known in the art. In particular, the unit cell can include a high manganese positive electrode having the highest manganese(Mn) content among the components.

The high-manganese positive electrode may include, as a positive electrode active material, a lithium transition metal oxide in which the manganese(Mn) content accounts for 50 mol% or more of the total transition metal content.

The lithium transition metal oxide may be specifically represented by the following Chemical Formula 1.

[Chemical Formula 1]      $Li_aNi_bMn_cM_dO_{2+e}$

in Chemical Formula 1,

$1.0 \leq a \leq 1.3$, $0 \leq b \leq 0.4$, $0.5 \leq c \leq 1.0$, $0 \leq d < 0.4$, $0 \leq e \leq 0.2$, and
M is at least one selected from the group consisting of Al, B, Co, Fe, Cr, Cu, W, Mg, V, Ti, Zn, Ga, In, Ru, Nb, Sn, Sr and Zr.

In addition, other components constituting the unit cell are not limited as long as they are those known to those skilled in the art in the technical field of the present disclosure, and can be applied to the present disclosure.

In addition, since terms, such as "including," "comprising," and "having" mean that one or more corresponding components may exist unless they are specifically described to the contrary, it shall be construed as further including other components rather than excluding other components. All of the terminologies containing one or more technical or scientific terminologies have the same meanings that persons skilled in the art understand ordinarily unless they are not defined otherwise. A term ordinarily used like that defined by a dictionary shall be construed that it has a meaning equal to those in the context of a related description, and shall not be construed in an ideal or excessively formal meaning unless it is clearly defined in the present specification.

**[Industrial Applicability]**

According to the embodiments of the present disclosure, the resistance characteristic of a unit cell can be accurately diagnosed based on the capacity voltage differential data of the unit cell as a new parameter, and the accuracy and reliability of the unit cell including the high-manganese positive electrode material are particularly high.

Furthermore, a unit cell for a secondary battery in which the new parameter satisfies a specific condition exhibits excellent effects, particularly, the effect of reducing the degree of aging of a battery.

In addition, various effects that are directly or indirectly identified through the present disclosure can be provided.

**Claims**

1. A device for diagnosing resistance characteristic, comprising:

   an acquisition unit that acquires a charging or discharging profile in a specified charge/discharge cycle of a unit cell;
   a generation unit that generates a capacity voltage differential data representing a capacity voltage differential value(dQ/dV) of the unit cell in a charge or discharge cycle included in the specified charge/discharge cycle, based on the charging or discharging profile; and
   a diagnosis unit that diagnoses resistance characteristic of the unit cell based on the capacity voltage differential data.

2. The device for diagnosing resistance characteristic according to claim 1, wherein:
   the diagnosis unit diagnoses the resistance characteristic of the unit cell, based on the maximum capacity voltage differential value of the capacity voltage differential data in the charge cycle, and the minimum capacity voltage differential value of the capacity voltage differential data in the discharge cycle.

3. The device for diagnosing resistance characteristic according to claim 2, wherein:

   the capacity voltage differential data represents a differential value of the capacity voltage to the voltage of the unit cell, and
   further comprises an identification unit that identifies a target voltage corresponding to a maximum or minimum capacity voltage differential value of the unit cell based on the capacity voltage differential data, and
   the diagnosis unit diagnoses the resistance characteristic of the unit cell based on the capacity voltage differential value retention at the target voltage of the unit cell.

4. The device for diagnosing resistance characteristic according to claim 3, wherein:

   the generation unit generates a first capacity voltage differential data corresponding to the first charge/discharge cycle and a second capacity voltage differential data corresponding to the second charge/discharge cycle after the first charge/discharge cycle, and
   the identification unit identifies the target voltage corresponding to the maximum capacity voltage differential value in the charge cycle or the minimum capacity voltage differential value in the discharge cycle, included in the first charge/discharge cycle of the unit cell, based on the first capacity voltage differential data, and

the diagnosis unit calculates the capacity voltage differential value retention based on the difference between the capacity voltage differential value at the target voltage of the charge cycle and the maximum capacity voltage differential value, or the difference between the capacity voltage differential value at the target voltage of the discharge cycle and the minimum capacity voltage differential value, included in the second charge/discharge cycle of the unit cell, based on the second capacity voltage differential data.

5. The device for diagnosing resistance characteristic according to claim 1, wherein:
the diagnosis unit diagnoses that as the capacity voltage differential value retention is smaller, the resistance increase of the unit cell is higher.

6. The device for diagnosing resistance characteristic according to claim 1, wherein:
the unit cell includes a high-manganese positive electrode having the highest manganese(Mn) content among the constituent components.

7. A method for diagnosing resistance characteristic comprising:

an operation that acquires a charging or discharging profile in a specified charge/discharge cycle of a unit cell;
an operation that generates a capacity voltage differential data representing a capacity voltage differential value(dQ/dV) of the unit cell in a charge or discharge cycle included in the specified charge/discharge cycle, based on the charging or discharging profile; and
an operation that diagnoses resistance characteristic of the unit cell based on the capacity voltage differential data.

8. The method for diagnosing resistance characteristic according to claim 7, wherein:
the operation that diagnoses resistance characteristic comprises an operation that diagnoses the resistance characteristic of the unit cell, based on the maximum capacity voltage differential value of the capacity voltage differential data in the charge cycle, and the minimum capacity voltage differential value of the capacity voltage differential data in the discharge cycle.

9. The method for diagnosing resistance characteristic according to claim 8, wherein:

the capacity voltage differential data represents a differential value of the capacity voltage to the voltage of the unit cell, and
further comprises an operation that identifies a target voltage corresponding to a maximum or minimum capacity voltage differential value of the unit cell based on the capacity voltage differential data, and
the operation that diagnoses resistance characteristic includes an operation that diagnoses the resistance characteristic of the unit cell based on the capacity voltage differential value retention at the target voltage of the unit cell.

10. The method for diagnosing resistance characteristic according to claim 9, wherein:

the operation that generates capacity voltage differential data comprises an operation that generates a first capacity voltage differential data corresponding to the first charge/discharge cycle and a second capacity voltage differential data corresponding to the second charge/discharge cycle after the first charge/discharge cycle, and
the operation that identifies a target voltage comprises an operation that identifies the target voltage corresponding to the maximum capacity voltage differential value in the charge cycle or the minimum capacity voltage differential value in the discharge cycle, included in the first charge/discharge cycle of the unit cell, based on the first capacity voltage differential data, and
the operation that diagnoses resistance characteristic includes an operation that calculates the capacity voltage differential value retention, based on the difference between the capacity voltage differential value at the target voltage of the charge cycle and the maximum capacity voltage differential value, or the difference between the capacity voltage differential value at the target voltage of the discharge cycle and the minimum capacity voltage differential value, included in the second charge/discharge cycle of the unit cell, based on the second capacity voltage differential data.

11. The method for diagnosing resistance characteristic according to claim 7, wherein:
the operation that diagnoses resistance characteristic includes an operation that diagnoses that as the capacity voltage differential value retention is smaller, the resistance increase of the unit cell is higher.

12. The method for diagnosing resistance characteristic according to claim 7, wherein:
the unit cell includes a high-manganese positive electrode having the highest manganese(Mn) content among the constituent components.

13. A unit cell for a secondary battery which satisfies the following Condition 1,

when a voltage corresponding to the maximum capacity voltage differential value($D_1$) obtained from a first capacity voltage differential data in a first charge cycle of the unit cell for a secondary battery is set as the target voltage(Vt), and a capacity voltage differential value($D_2$) corresponding to the target voltage ($V_t$) is obtained from a second capacity voltage differential data in a second charge/discharge cycle of the unit cell, or
when a voltage corresponding to the minimum capacity voltage differential value($D_1$) obtained from a first capacity voltage differential data in the first discharge cycle of the unit cell for a secondary battery is set as the target voltage ($V_t$), and a capacity voltage differential value($D_2$) corresponding to the target voltage($V_t$) is obtained from the second capacity voltage differential data in the second charge/discharge cycle of the unit cell.

[Condition 1]

$$D_2/D_1 * 100\% > 70\%.$$

14. The unit cell for a secondary battery according to claim 13, wherein:
the charging of the unit cell is performed in CC-CV charge mode at 0.1C to 1C in a range of 2V to 4.25V, or 3V to 4.3V, or 2V to 4.35V, and the discharging of the unit cell is performed in CC charge mode at 0.1C to 1C in a range of 2V to 4.25V, or 3V to 4.3V, or 2V to 4.35V.

15. The unit cell for a secondary battery according to claim 13, wherein:
the unit cell includes a high-manganese positive electrode having the highest manganese(Mn) content among the constituent components.

# FIG. 1

100

# FIG. 2

100'

# FIG. 3

Device for diagnosing resistance increase
200

Communication circuit
210

Sensor
220

Memory
230

Processor
240

Acquisition unit
231

Generation unit
233

Identification unit
235

Diagnosis unit
237

# FIG. 4

300

# FIG. 5

300'

# FIG. 6

```
         ( Start )
             │
             ▼
┌──────────────────────────────────────┐
│ Acquiring a charging / discharging    │
│ profile in                            │ ~405
│ a specified charge/discharge cycle    │
│ of unit cell                          │
└──────────────────────────────────────┘
             │
             ▼
┌──────────────────────────────────────┐
│ Generating capacity voltage           │
│ differentiation                       │ ~410
│ data in charge / discharge cycles     │
│ of unit cell                          │
└──────────────────────────────────────┘
             │
             ▼
┌──────────────────────────────────────┐
│ Diagnosing resistance increase        │ ~415
└──────────────────────────────────────┘
             │
             ▼
          ( End )
```

# FIG. 7

```
                    ( Start )
                        │
                        ▼
┌──────────────────────────────────────────┐
│  Acquiring the first discharging profile in │ ─── 505
│  the first charge / discharge cycle of unit cell │
└──────────────────────────────────────────┘
                        │
                        ▼
┌──────────────────────────────────────────┐
│  Generating first capacity voltage differential │ ─── 510
│  data based on the first discharging profile │
└──────────────────────────────────────────┘
                        │
                        ▼
┌──────────────────────────────────────────┐
│        Identifying target voltage based on       │ ─── 515
│      first capacity voltage differential data    │
└──────────────────────────────────────────┘
                        │
                        ▼
┌──────────────────────────────────────────┐
│ Acquiring the second discharging profile in   │ ─── 520
│ the second charge/discharge cycle of unit cell │
└──────────────────────────────────────────┘
                        │
                        ▼
┌──────────────────────────────────────────┐
│ Generating second capacity voltage differential │ ─── 525
│ data based on the second discharging profile  │
└──────────────────────────────────────────┘
                        │
                        ▼
┌──────────────────────────────────────────┐
│          Calculating the capacity voltage        │ ─── 530
│          differential value retention            │
└──────────────────────────────────────────┘
                        │
                        ▼
┌──────────────────────────────────────────┐
│   Diagnosing resistance increase of unit cell   │ ─── 535
└──────────────────────────────────────────┘
                        │
                        ▼
                    ( End )
```

# FIG. 8

Start

Acquiring the first charging profile in
the first charge / discharge cycle of unit cell ~505'

Generating first capacity voltage differential
data based on the first charging profile ~510'

Identifying target voltage based on
first capacity voltage differential data ~515'

Acquiring the second charging profile in
the second charge / discharge cycle of unit cell ~520'

Generating second capacity voltage differential
data based on the second charging profile ~525'

Calculating the capacity voltage
differential value retention ~530'

Diagnosing resistance increase of unit cell ~535'

End

## INTERNATIONAL SEARCH REPORT

| International application No. |
| --- |
| **PCT/KR2024/011477** |

| A. | CLASSIFICATION OF SUBJECT MATTER |
| --- | --- |

**G01R 31/389**(2019.01)i; **G01R 31/396**(2019.01)i; **G01R 31/392**(2019.01)i; **G01R 31/385**(2019.01)i; **G01R 31/382**(2019.01)i; **G01R 19/165**(2006.01)i; **G01R 27/02**(2006.01)i; **H01M 4/36**(2006.01)i

According to International Patent Classification (IPC) or to both national classification and IPC

| B. | FIELDS SEARCHED |
| --- | --- |

Minimum documentation searched (classification system followed by classification symbols)

G01R 31/389(2019.01); B60L 58/18(2019.01); G01R 31/02(2006.01); G01R 31/36(2006.01); G01R 31/392(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 미분(differentiation), 저항(impedance), 전압(voltage), 진단(diagnosis)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | KR 10-2021-0031226 A (LG CHEM, LTD.) 19 March 2021 (2021-03-19)<br>See paragraphs [0048]-[0177], claim 1 and figures 1 and 6. | 1-15 |
| A | KR 10-2020-0122903 A (LG CHEM, LTD.) 28 October 2020 (2020-10-28)<br>See paragraphs [0057]-[0072], claim 1 and figure 2. | 1-15 |
| A | KR 10-2010-0002151 A (SONY CORPORATION) 06 January 2010 (2010-01-06)<br>See paragraphs [0035]-[0089] and figures 3-10. | 1-15 |
| A | KR 10-2022-0019564 A (LG ENERGY SOLUTION, LTD.) 17 February 2022 (2022-02-17)<br>See paragraphs [0026]-[0046], claims 14-17 and figures 2-4. | 1-15 |
| A | KR 10-2021-0033764 A (LG CHEM, LTD.) 29 March 2021 (2021-03-29)<br>See paragraphs [0078]-[0089], claims 1 and 12 and figure 5. | 1-15 |

| ☐ Further documents are listed in the continuation of Box C. | ☑ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **04 November 2024** | **05 November 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

### INTERNATIONAL SEARCH REPORT
#### Information on patent family members

| International application No. |
| --- |
| **PCT/KR2024/011477** |

| Patent document cited in search report | | | Publication date (day/month/year) | Patent family member(s) | | | Publication date (day/month/year) |
| --- | --- | --- | --- | --- | --- | --- | --- |
| KR | 10-2021-0031226 | A | 19 March 2021 | CN | 114270202 | A | 01 April 2022 |
| | | | | CN | 114270202 | B | 09 April 2024 |
| | | | | EP | 4012427 | A1 | 15 June 2022 |
| | | | | EP | 4012427 | B1 | 17 July 2024 |
| | | | | JP | 2022-539744 | A | 13 September 2022 |
| | | | | JP | 7279294 | B2 | 23 May 2023 |
| | | | | US | 11874330 | B2 | 16 January 2024 |
| | | | | US | 2022-0276314 | A1 | 01 September 2022 |
| | | | | WO | 2021-049882 | A1 | 18 March 2021 |
| KR | 10-2020-0122903 | A | 28 October 2020 | CN | 112601969 | A | 02 April 2021 |
| | | | | CN | 112601969 | B | 05 April 2024 |
| | | | | EP | 3872509 | A1 | 01 September 2021 |
| | | | | JP | 2022-502629 | A | 11 January 2022 |
| | | | | JP | 7148049 | B2 | 05 October 2022 |
| | | | | US | 11955828 | B2 | 09 April 2024 |
| | | | | US | 2021-0344212 | A1 | 04 November 2021 |
| | | | | WO | 2020-214000 | A1 | 22 October 2020 |
| KR | 10-2010-0002151 | A | 06 January 2010 | CN | 101615706 | A | 30 December 2009 |
| | | | | CN | 101615706 | B | 26 September 2012 |
| | | | | JP | 2010-008067 | A | 14 January 2010 |
| | | | | JP | 4591560 | B2 | 01 December 2010 |
| | | | | US | 2009-0315520 | A1 | 24 December 2009 |
| | | | | US | 2012-0146586 | A1 | 14 June 2012 |
| | | | | US | 8203306 | B2 | 19 June 2012 |
| | | | | US | 8629656 | B2 | 14 January 2014 |
| KR | 10-2022-0019564 | A | 17 February 2022 | CN | 115552262 | A | 30 December 2022 |
| | | | | EP | 4134686 | A1 | 15 February 2023 |
| | | | | JP | 2023-524846 | A | 13 June 2023 |
| | | | | JP | 7501976 | B2 | 18 June 2024 |
| | | | | US | 2023-0194622 | A1 | 22 June 2023 |
| | | | | WO | 2022-035151 | A1 | 17 February 2022 |
| KR | 10-2021-0033764 | A | 29 March 2021 | CN | 113711461 | A | 26 November 2021 |
| | | | | CN | 113711461 | B | 21 November 2023 |
| | | | | EP | 3982141 | A1 | 13 April 2022 |
| | | | | EP | 3982141 | B1 | 14 February 2024 |
| | | | | ES | 2975509 | T3 | 08 July 2024 |
| | | | | HU | E065724 | T2 | 28 June 2024 |
| | | | | JP | 2022-520765 | A | 01 April 2022 |
| | | | | JP | 7159524 | B2 | 25 October 2022 |
| | | | | PL | 3982141 | T3 | 13 May 2024 |
| | | | | US | 12007449 | B2 | 11 June 2024 |
| | | | | US | 2022-0158468 | A1 | 19 May 2022 |
| | | | | WO | 2021-054618 | A1 | 25 March 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230102310
- KR 1020230102680
- KR 1020240102964